# EUROPÄISCHE PATENTANMELDUNG

(11) **EP 4 016 682 A1**
(43) Veröffentlichungstag der Anmeldung: **22.06.2022**
(21) Anmeldenummer: 20214694.0
(22) Anmeldetag: 16.12.2020
(51) Int. Cl.: H01M 10/04, H01M 50/20, H01M 50/216, H01M 50/284, H01R 12/57, H05K 3/32

(54) **HALTERUNG FÜR EINE KNOPFZELLE, ANORDNUNG MIT EINER HALTERUNG UND VERFAHREN ZUM AUTOMATISCHEN MONTIEREN EINER HALTERUNG**

(71) Anmelder: Würth Elektronik eiSos GmbH & Co. KG, 74638 Waldenburg (DE)
(72) Erfinder: Treml, Alexander, 74235 Erlenbach (DE); Sanwald, Julia, 75015 Bretten (DE); Klingler, Stefan, 74544 Michelbach/Bilz (DE)
(74) Vertreter: Patentanwälte Ruff, Wilhelm, Beier, Dauster & Partner mbB

(57) **Zusammenfassung**

Die Erfindung betrifft eine Halterung für eine Knopfzelle, wobei die Halterung zum Befestigen auf einer Leiterplatte vorgesehen ist, wobei die Halterung wenigstens zwei erste Rastarme aufweist, die im montierten Zustand der Halterung von der Leiterplatte abragen, wobei die Knopfzelle im montierten Zustand der Knopfzelle zwischen den ersten Rastarmen aufgenommen ist, wobei die ersten Rastarme an einem Ende jeweils mit einem Grundkörper verbunden sind, der eine Grundfläche aufweist, die im montierten Zustand der Halterung mit der Leiterplatte verbunden ist, wobei die ersten Rastarme jeweils wenigstens eine erste Rastnase aufweisen, um die Knopfzelle an der Leiterplatte zu halten, und wobei die ersten Rastnasen in einem ersten Abstand von der Grundfläche des Grundkörpers angeordnet sind.

## Beschreibung

Die Erfindung betrifft eine Halterung für eine Knopfzelle, wobei die Halterung zum Befestigen auf einer Leiterplatte vorgesehen ist. Die Erfindung betrifft auch eine Anordnung mit einer erfindungsgemäßen Halterung und einer Leiterplatte. Die Erfindung betrifft darüber hinaus ein Verfahren zum automatischen Montieren einer Halterung auf einer Leiterplatte.

Aus der US-Patentschrift US 6,722,916 B2 ist eine Anordnung mit einer Halterung für eine Knopfzelle bekannt, wobei die Halterung auf eine Leiterplatte aufgesetzt ist. Die Halterung ist an Lötflächen auf der Leiterplatte angelötet. Die Halterung weist einen allgemein U-förmigen Querschnitt auf, wobei die allgemein U-förmige Halterung so auf die Leiterplatte aufgesetzt wird, dass eine Knopfzelle parallel zur Leiterplatte in die allgemein U-förmige Halterung eingeschoben wird. Die Halterung weist ausgehend von dem U-förmigen Bügel drei Haltearme auf, die auf eine Oberseite der Knopfzelle drücken und diese dadurch gegen die Leiterplatte drücken. Innerhalb des U-Bügels der Halterung ist ein zweiter elektrischer Kontakt auf der Leiterplatte angeordnet, gegen den die Knopfzelle mittels der Haltearme gedrückt wird. Der Kontakt ist kreisrund mit quadratischen Öffnungen ausgebildet, so dass der Kontakt dadurch ein waffeleisenartiges Aussehen hat. Eine Knopfzelle muss in die Halterung seitlich, parallel zur Leiterplatte eingeschoben werden. Dies ist nicht bzw. nicht ohne weiteres vollautomatisch möglich.

Mit der Erfindung soll eine Halterung für eine Knopfzelle, eine Anordnung mit einer Halterung und einer Leiterplatte sowie ein Verfahren zum automatischen Montieren einer Halterung auf einer Leiterplatteverbessert werden.

Erfindungsgemäß ist hierzu eine Halterung mit den Merkmalen von Anspruch 1 und eine Anordnung mit den Merkmalen von Anspruch 14 und ein Verfahren mit den Merkmalen von Anspruch 19 vorgesehen. Vorteilhafte Weiterbildungen der Erfindung sind in den Unteransprüchen angegeben.

Eine erfindungsgemäße Halterung für eine Knopfzelle ist zum Befestigen auf einer Leiterplatte vorgesehen und weist wenigstens zwei erste Rastarme auf, die im montierten Zustand der Halterung von der Leiterplatte abragen, wobei die Knopfzelle im montierten Zustand der Knopfzelle zwischen den ersten Rastarmen aufgenommen ist, wobei die ersten Rastarme an einem Ende jeweils mit einem Grundkörper verbunden sind, der eine Grundfläche aufweist, die im montierten Zustand der Halterung mit der Leiterplatte verbunden ist, wobei die ersten Rastarme jeweils wenigstens eine erste Rastnase aufweisen, um die Knopfzelle an der Leiterplatte zu halten, und wobei die ersten Rastnasen in einem ersten Abstand von der Grundfläche des Grundkörpers angeordnet sind.

Mittels von der Leiterplatte abragenden Rastarmen und Rastnasen an den Rastarmen kann eine Knopfzelle in einfacher Weise manuell oder mittels eines Greifers zwischen die Rastarme eingeschoben werden. Dies geschieht so lange, bis die Rastnasen ein Stück weit über die Knopfzelle schnappen und diese dadurch sicher an der Leiterplatte halten. Die Halterung ist infolgedessen so ausgebildet, dass durch einfaches Eindrücken einer Knopfzelle in die Halterung die Knopfzelle zum einen zuverlässig elektrisch kontaktiert und gleichzeitig auch zuverlässig an der Leiterplatte gehalten werden kann. Die Knopfzelle kann also senkrecht zur Leiterplatte in die Halterung eingedrückt werden. Das vollautomatische Einsetzen der Knopfzelle ist dadurch einfach und prozesssicher möglich.

In Weiterbildung der Erfindung weist die Halterung wenigstens zwei zweite Rastarme auf, die im montierten Zustand der Halterung von der Leiterplatte abragen, wobei die Knopfzelle im montierten Zustand der Knopfzelle zwischen den zweiten Rastarmen aufgenommen ist, wobei die zweiten Rastarme an einem Ende jeweils mit dem Grundkörper verbunden sind, wobei die zweiten Rastarme jeweils wenigstens eine zweite Rastnase aufweisen, um eine Knopfzelle mit von der ersten Knopfzelle unterschiedlicher Höhe an der Leiterplatte zu halten, und wobei die zweiten Rastnasen in einem zweiten Abstand von der Grundfläche des Grundkörpers angeordnet sind, wobei der zweite Abstand von dem ersten Abstand verschieden ist.

Mit der erfindungsgemäßen Halterung können dadurch Knopfzellen unterschiedlicher Höhe an der Leiterplatte gehalten werden oder auch zwei Knopfzellen übereinander mit unterschiedlicher oder gleicher Höhe. Je nachdem, ob eine Knopfzelle mit einer ersten Höhe oder eine Knopfzelle mit einer zweiten Höhe in die Halterung eingesetzt wird, übergreifen entweder die ersten Rastnasen oder die zweiten Rastnasen eine Oberseite der Knopfzelle abschnittsweise. Wird beispielsweise eine Knopfzelle mit kleinerer Höhe eingesetzt, so halten im endgültig montierten Zustand die zweiten Rastnasen die Knopfzelle an der Leiterplatte, die ersten Rastnasen sind hingegen frei und werden an und für sich nicht benötigt. Wird eine Knopfzelle einer ersten, größeren Höhe eingesetzt, werden die zweiten Rastnasen mit den zweiten Rastarmen zwar ausgelenkt, können aber nicht über die Oberseite der Knopfzelle zurückschnappen. Die Knopfzelle wird infolgedessen lediglich durch die ersten Rastnasen abschnittsweise übergriffen und an der Leiterplatte gehalten. Die zweiten Rastarme mit den zweiten Rastnasen tragen dann lediglich zu einem guten elektrischen Kontakt zwischen einer Außenwand der Knopfzelle und der Halterung bei, wenn die Halterung aus elektrisch leitfähigem Material besteht. In überraschend einfacher Weise können dadurch Knopfzellen mit unterschiedlicher Höhe in ein- und derselben Halterung angeordnet werden. Werden zwei Knopfzellen übereinander angeordnet, wird die erste, untere Knopfzelle beispielsweise durch die ersten Rastnasen abschnittsweise übergriffen und die zweite, obere Knopfzelle wird durch die zweiten Rastnasen abschnittsweise übergriffen. Dies ermöglicht es, die erfindungsgemäße Halterung in sehr großen Stückzahlen und dadurch kostengünstig herzustellen. Die Halterung ist dabei für Knopfzellen unterschiedlicher Höhe aber gleichem Radius geeignet.

In Weiterbildung der Erfindung sind die Rastarme und der Grundkörper elektrisch leitfähig ausgebildet.

Auf diese Weise kann die Halterung als erster elektrischer Kontakt für die Knopfzelle dienen.

In Weiterbildung der Erfindung sind die Rastarme als gebogene Blechstreifen ausgebildet.

Mittels gebogener Blechstreifen lässt sich zum einen ein sicherer elektrischer Kontakt und zum anderen eine sehr zuverlässige Rastwirkung erreichen.

In Weiterbildung der Erfindung ist die Halterung als einstückiges Blechstanzteil und Blechbiegeteil ausgebildet.

Auf diese Weise ist die gesamte Halterung elektrisch leitfähig und kann als erster elektrischer Kontakt zum Kontaktieren der Knopfzelle dienen. Zum anderen lassen sich die Rastarme mit der benötigten Federkraft in sehr einfacher Weise herstellen. Eine Federkraft der Rastarme kann durch eine Breite der Blechstreifen, die die Rastarme bilden, eingestellt werden sowie selbstverständlich auch über die Materialauswahl des Blechs. Die gesamte Halterung lässt sich als Blechstanzteil und Blechbiegeteil kostengünstig und in sehr großen Stückzahlen herstellen.

In Weiterbildung der Erfindung ist wenigstens eine der Rastnasen mittels eines wenigstens abschnittsweise parallel zur Leiterplatte und/oder wenigstens abschnittsweise schräg zur Leiterplatte angeordneten Halteabschnitts gebildet.

Der Halteabschnitt bildet dadurch einen Hinterschnitt, hinter den die Knopfzelle beim Einführen in die Halterung schnappt. Wenn der Rastarm als Blechstreifen ausgebildet ist, kann der Halteabschnitt und damit die Rastnase durch einfaches Abbiegen des Blechstreifens hergestellt werden.

In Weiterbildung der Erfindung weist jeder Rastarm einen Verbindungsabschnitt auf, der einerseits mit dem Grundkörper und andererseits mit dem Halteabschnitt verbunden ist, und der Halteabschnitt ist auf einer, dem Verbindungsabschnitt gegenüberliegenden Seite mit einem Einführabschnitt verbunden, der im montierten Zustand der Halterung wenigstens abschnittsweise schräg zur Leiterplatte angeordnet ist.

Der Einführabschnitt erstreckt sich dadurch ausgehend vom Halteabschnitt schräg von einem Mittelpunkt der Halterung bzw. der Knopfzelle weg und kann dadurch als Einführschräge für die Knopfzelle dienen. Wenn die Knopfzelle auf die Einführschräge aufläuft, wird der Rastarm dadurch radial nach außen ausgelenkt. Sobald die Knopfzelle weit genug in die Halterung eingedrückt ist und die Einlaufschräge verlassen hat, wird der Rastarm zurückschnappen, so dass der Halteabschnitt wenigstens abschnittsweise eine Oberseite der Knopfzelle übergreifen und die Knopfzelle dadurch sicher an der Leiterplatte halten kann.

In Weiterbildung der Erfindung weist die Halterung wenigstens zwei Einführarme auf, die im montierten Zustand der Halterung von der Leiterplatte abragen, wobei die Knopfzelle im montierten Zustand der Knopfzelle zwischen den Einführarmen aufgenommen ist und wobei die Einführarme an einem ersten Ende mit dem Grundkörper verbunden sind und wobei ein zweites Ende der Einführarme, das dem ersten Ende gegenüberliegt, weiter von der Grundfläche des Grundkörpers beabstandet ist als die ersten und zweiten Rastnasen.

Die Knopfzelle läuft beim Einsetzen in die Halterung, das durch eine Bewegung senkrecht zur Leiterplatte auf die Leiterplatte zu erfolgt, infolgedessen zunächst auf die Einführarme auf. Die Einführarme können mit Einführschrägen versehen sein, die die Knopfzelle automatisch korrekt positionieren. Beispielsweise sind drei bis sechs Einführarme mit jeweils einer Einführschräge vorgesehen. Die Knopfzelle wird mittels dieser Einführarme und Einführschrägen in radialer Richtung exakt zur Halterung zentriert. Die Einführarme zentrieren die Knopfzelle, so dass beim weiteren Zustellen der Knopfzelle in Richtung auf die Leiterplatte zu die Knopfzelle die ersten Rastarme und/oder die zweiten Rastarme problemlos auslenken kann, bis die Knopfzelle ihre endgültige Position erreicht hat und die Rastarme in die Halteposition zurückschnappen.

In Weiterbildung der Erfindung weist der Grundkörper eine gebogene Form auf und umgibt einen Rand der Knopfzelle im montierten Zustand der Halterung und der Knopfzelle wenigstens abschnittsweise.

In Weiterbildung der Erfindung ist der Grundkörper ringförmig oder ringabschnittsförmig ausgebildet.

In Weiterbildung der Erfindung weist die Grundfläche des Grundkörpers wenigstens zwei Befestigungsabschnitte auf, die im montierten Zustand der Halterung auf der Leiterplatte aufliegen.

Mittels solcher Befestigungsabschnitte kann die Halterung in einfacher Weise auf passende Lötflächen auf der Leiterplatte aufgelegt und mit den Lötflächen verlötet werden. Die Halterung kann dadurch prozesssicher automatisch bestückt werden,

In Weiterbildung der Erfindung ist wenigstens einer der Befestigungsabschnitte als Ansaugfläche für einen Unterdruckgreifer ausgebildet.

Beispielsweise ist einer der Befestigungsabschnitte vergleichsweise groß und im montierten Zustand parallel zu einer Oberseite der Leiterplatte angeordnet. An diesem Befestigungsabschnitt kann die Halterung ergriffen werden, beispielsweise mittels eines Unterdruckgreifers, und dann vollautomatisch auf die Oberseite der Leiterplatte aufgesetzt und auf der Oberseite befestigt werden, beispielsweise verlötet werden. Die Halterung kann dadurch vollautomatisch auf einer Leiterplatte montiert werden.

In Weiterbildung der Erfindung sind drei erste Rastarme, drei zweite Rastarme und wenigstens drei Einführarme, insbesondere sechs Einführarme, mit dem Grundkörper verbunden.

Mittels dreier Rastarme, die vorzugsweise in einem Abstand von 120° zueinander über den Umfang des Grundkörpers der Halterung verteilt sind, kann eine Knopfzelle sicher zwischen den ersten Rastarmen und/oder den zweiten Rastarmen gehalten werden. Der Winkel zwischen den jeweiligen Rastarmen kann dabei exakt 120° betragen, kann aber auch von diesem Winkelwert abweichen, wenn beispielsweise die räumlichen Verhältnisse dies erfordern.

Auf dem Umfang des Grundkörpers benachbart zu den Rastarmen können die Einführarme vorgesehen sein. Beispielsweise sind entlang des Umfangs gesehen jeweils ein erster Rastarm und ein zweiter Rastarm zwischen zwei Einführarmen angeordnet. Dadurch ist sichergestellt, dass beim Einsetzen einer Knopfzelle in die Halterung der untere Rand der Knopfzelle präzise zu den jeweiligen ersten Rastarmen und zweiten Rastarmen ausgerichtet ist, bevor der untere Rand auf die ersten oder zweiten Rastarme aufläuft.

Die Erfindung betrifft auch eine Anordnung mit einer erfindungsgemäßen Halterung und einer Leiterplatte, wobei die Halterung so auf der Leiterplatte befestigt ist, dass die wenigstens zwei ersten Rastnasen in einer ersten Höhe oberhalb der Leiterplatte angeordnet sind. Die ersten Rastarme mit den ersten Rastnasen sind infolgedessen dafür vorgesehen, eine Knopfzelle mit einer ersten Höhe an der Leiterplatte zu halten.

In Weiterbildung der Erfindung sind die zweiten Rastnasen in einer zweiten Höhe, die von der ersten Höhe verschieden ist, oberhalb der Leiterplatte angeordnet.

Die zweiten Rastarme und die zweiten Rastnasen sind infolgedessen dafür vorgesehen, eine Knopfzelle mit einer zweiten Höhe an der Leiterplatte zu halten.

In Weiterbildung der Erfindung ragen die wenigstens zwei Einführarme von der Leiterplatte aus gesehen über die ersten Rastarme und/oder die zweiten Rastarme hinaus.

Wenn eine Knopfzelle daher in die Halterung eingesetzt wird, berührt sie zunächst die Einführarme und kann dadurch in einer Richtung parallel zur Leiterplatte ausgerichtet werden. Wenn der untere Rand der Knopfzelle dann auf die ersten Rastarme und/oder die zweiten Rastarme trifft, ist die Knopfzelle exakt ausgerichtet, also zur Halterung zentriert, so dass die ersten Rastnasen und/oder die zweiten Rastnasen radial nach außen gedrückt werden können, bis die Knopfzelle so weit in Richtung auf die Leiterplatte zugestellt ist, dass die ersten Rastnasen und/oder die zweiten Rastnasen zurückschnappen und die Oberseite der Knopfzelle abschnittsweise übergreifen.

In Weiterbildung der Erfindung bildet wenigstens ein Abschnitt der Halterung einen ersten elektrischen Kontakt zum Kontaktieren einer in der Halterung angeordneten Knopfzelle und auf der Leiterplatte ist wenigstens ein zweiter elektrischer Kontakt zum Kontaktieren der in der Halterung angeordneten Knopfzelle angeordnet, wobei der zweite elektrische Kontakt wenigstens eine kreisringabschnittsförmige oder kreisringförmige Kontaktfläche aufweist.

Mittels einer kreisringförmigen oder kreisringabschnittsförmigen Kontaktfläche kann die Unterseite einer Knopfzelle besonders sicher kontaktiert werden. Es kann oft beobachtet werden, dass die Unterseiten von Knopfzellen nicht exakt eben sind, sondern üblicherweise sogar leicht konvex geformt sind. Mittels einer kreisringabschnittsförmigen oder kreisringförmigen Kontaktfläche können solche Toleranzen oder Formabweichungen problemlos kompensiert werden und es kann eine sichere elektrische Kontaktierung gewährleistet werden. Im Rahmen der Erfindung kann die Unterseite der Knopfzelle auch mit einem Kontakt beliebiger Form kontaktiert werden.

In Weiterbildung der Erfindung ist eine Außenkante der Kontaktfläche in radialer Richtung und parallel zur Leiterplatte gesehen nur um 1/20 bis 1/5 des Radius der Knopfzelle, insbesondere 1/20 bis 1/10 des Radius der Knopfzelle, von dem ersten und/oder zweiten Rastarm beabstandet.

Am Rand der Knopfzelle ist die metallische Knopfzelle durch die Kante zwischen dem Rand und der Unterseite besonders stabil und weist in diesem Bereich auch üblicherweise nur geringe Toleranzen auf, jedenfalls im Vergleich zur Mitte der Unterseite der Knopfzelle. Nur wenig beabstandet vom äußeren Rand der Knopfzelle kann diese dadurch zuverlässig elektrisch kontaktiert werden.

Beim automatischen Einsetzen einer Knopfzelle in eine erfindungsgemäße Anordnung ist das Ausrichten der Knopfzelle mittels eines Greifers oder Manipulators in der Weise vorgesehen, dass eine Unterseite der Knopfzelle parallel zur Oberseite der Leiterplatte ausgerichtet ist und die Knopfzelle oberhalb der Halterung angeordnet ist. Anschließend an das Ausrichten der Knopfzelle erfolgt das Zustellen der Knopfzelle senkrecht zur Oberseite der Leiterplatte auf die Leiterplatte zu, bis ein unterer umlaufender Rand der Knopfzelle die jeweils oberen Enden der ersten und/oder zweiten Rastarme berührt. Dann erfolgt ein weiteres Zustellen der Knopfzelle senkrecht zur Leiterplatte auf die Leiterplatte zu, um die ersten und/oder zweiten Rastarme in radialer Richtung auszulenken. Dann erfolgt ein weiteres Zustellen der Knopfzelle senkrecht zur Leiterplatte auf die Leiterplatte zu, bis die Rastnasen an den ersten und/oder zweiten Rastarmen in radialer Richtung zurückschnappen und eine Oberseite der Knopfzelle abschnittsweise übergreifen.

Die erfindungsgemäße Halterung kann infolgedessen in sehr einfacher Weise vollautomatisch mit einer Knopfzelle bestückt werden. Gegebenenfalls an der erfindungsgemäßen Halterung vorgesehene Einführarme können eine radiale Ausrichtung der Knopfzelle, also parallel zur Oberseite der Leiterplatte, bewirken, bevor die Knopfzelle auf die Rastarme auftrifft, so dass die Knopfzelle in der exakt vorgegebenen Position auf die Rastarme auftrifft und diese dadurch zuverlässig in radialer Richtung auslenken kann. Auch das manuelle Bestücken der Halterung mit einer Knopfzelle ist sehr einfach und schnell zu bewirken.

Bei einem erfindungsgemäßen Verfahren zum automatischen Montieren einer Halterung auf einer Leiterplatte, wobei die Halterung wenigstens einen Befestigungsabschnitt aufweist, an dem ein Greifer angreifen kann, sind die Schritte Ergreifen der Halterung mittels Angreifen des Greifers an dem Befestigungsabschnitt, Positionieren der Halterung relativ zu Anschlussflächen auf der Leiterplatte und Aufsetzen der Halterung auf die Leiterplatte vorgesehen.

Durch das Vorsehen wenigstens eines Befestigungsabschnitts, der insbesondere im montierten Zustand parallel zur Leiterplatte angeordnet ist, kann die Halterung beispielsweise mittels eines Unterdruckgreifers in sehr einfacher Weise ergriffen, positioniert und dann auf die Leiterplatte aufgesetzt werden. Der Befestigungsabschnitt oder mehrere Befestigungsabschnitte können so ausgebildet sein, dass die jeweiligen Unterseiten der Befestigungsabschnitte dann auch als elektrische Kontaktflächen zu passenden Anschlussflächen auf der Leiterplatte verwendet werden können.

Bei dem erfindungsgemäßen Verfahren kann der Schritt des Verlötens der Halterung mit wenigstens einer Anschlussfläche auf der Leiterplatte vorgesehen sein. Durch einfaches Verlöten wird dadurch zum einen eine sichere mechanische Befestigung und zum anderen eine elektrische Verbindung zwischen den Anschlussflächen der Leiterplatte und der Halterung erreicht. Es ist im Rahmen der Erfindung aber auch durchaus möglich, die Halterung mechanisch an der Leiterplatte zu befestigen und die elektrische Kontaktierung dann separat, beispielsweise mittels Drähten oder dergleichen, vorzusehen.

Weitere Merkmale und Vorteile der Erfindung ergeben sich aus den Ansprüchen und der folgenden Beschreibung einer bevorzugten Ausführungsform der Erfindung im Zusammenhang mit den Zeichnungen. Einzelmerkmale der in den Zeichnungen dargestellten Ausführungsformen können dabei in beliebiger Weise miteinander kombiniert werden, ohne den Rahmen der Erfindung zu überschreiten. Dies gilt auch für die Kombination von Einzelmerkmalen oder weitere Einzelmerkmale, mit denen sie im Zusammenhang beschrieben und/oder gezeigt sind. In den Zeichnungen zeigen:
- Fig. 1: eine erfindungsgemäße Anordnung mit einer Halterung, die auf einer Leiterplatte angeordnet ist und einer in die Halterung eingesetzten ersten Knopfzelle in einer Ansicht von schräg oben,
- Fig. 2: die Anordnung der Fig. 1 ohne die Knopfzelle,
- Fig. 3: die Anordnung der Fig. 2 in einer Ansicht von oben,
- Fig. 4: die erfindungsgemäße Halterung in einer Ansicht von schräg oben,
- Fig. 5: die Halterung der Fig. 4 in einer Ansicht von schräg unten,
- Fig. 6: eine vergrößerte Einzelheit der Halterung der Fig. 4 und 5,
- Fig. 7: eine Schnittansicht der Anordnung der Fig. 1,
- Fig. 8: eine Ansicht der gemäß Fig. 7 geschnittenen Anordnung von oben zur Verdeutlichung der Lage der Schnittebene,
- Fig. 9: eine geschnittene Ansicht der erfindungsgemäßen Anordnung, wobei gegenüber der Darstellung der Fig. 7 eine zweite Knopfzelle mit geringerer Höhe in die Halterung eingesetzt ist,
- Fig. 10: eine Ansicht der geschnittenen Anordnung der Fig. 9 von oben zur Verdeutlichung der Lage der Schnittebene und
- Fig. 11: eine weitere geschnittene Ansicht der erfindungsgemäßen Anordnung, wobei die Schnittebene in Fig. 11 durch zwei einander gegenüberliegende Einführarme verläuft.

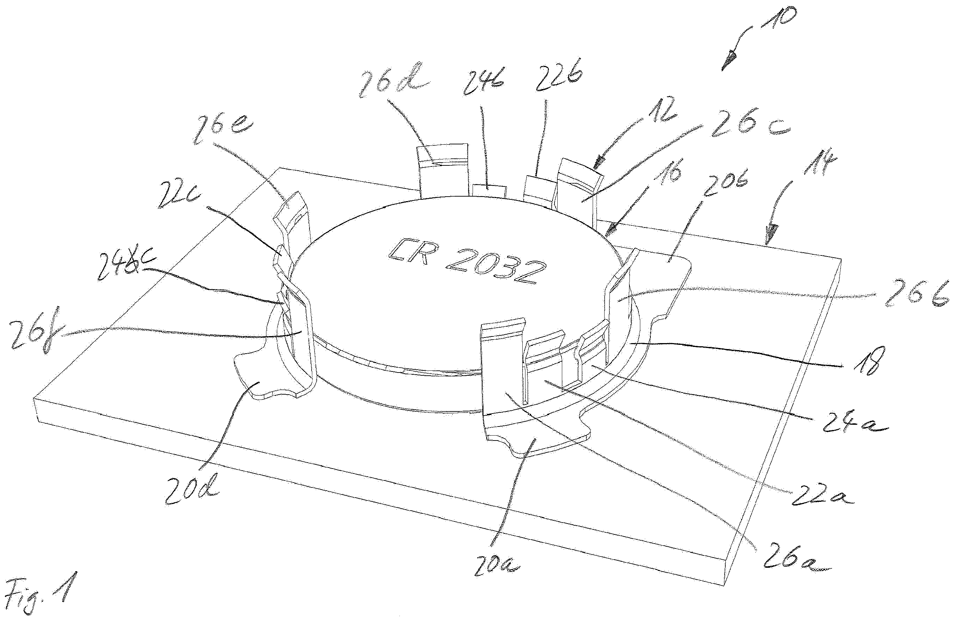

Fig. 1 zeigt eine erfindungsgemäße Anordnung 10 von schräg oben. Die Anordnung 10 weist eine Halterung 12 auf, die auf die Oberseite einer Leiterplatte 14 aufgesetzt ist. Die Halterung 12 ist elektrisch mit nicht dargestellten Lötflächen und Leiterbahnen auf der Oberseite der Leiterplatte 14 verbunden. Die Halterung 12 ist dadurch fest und unverrückbar auf der Oberseite der Leiterplatte 14 befestigt.

In die Halterung 12 ist eine erste Knopfzelle 16 eingesetzt. Die Knopfzelle ist vom Typ CR2032 und weist einen Durchmesser von 20 mm und eine Höhe von 3,2 mm auf.

Die Halterung 12 ist elektrisch leitfähig als einstückiges Blechstanz- und Blechbiegeteil ausgebildet. Die Halterung weist einen kreisringabschnittsförmigen Grundkörper 18 auf, der mit insgesamt vier Befestigungsabschnitten 20a, 20b, 20c und 20d versehen ist, wobei der Befestigungsabschnitt 20c in der Darstellung der Fig. 1 durch die Knopfzelle 16 verdeckt ist. Der Befestigungsabschnitt 20b ist so groß ausgeführt, dass er als Ansaugfläche für einen Sauggreifer dienen kann. Zum Montieren der Halterung 12 auf der Oberseite der Leiterplatte 14 kann die Halterung 12 somit mittels eines Unterdruckgreifers an dem Befestigungsabschnitt 20b ergriffen und in der gewünschten Position auf der Oberseite der Leiterplatte 14 abgesetzt werden. In dieser gewünschten Position wird die Halterung 12 dann mittels des Unterdruckgreifers gehalten, während die Befestigungsabschnitte 20a, 20b, 20c und 20d mit nicht dargestellten Befestigungsflächen auf der Leiterplatte 14 verlötet werden. Die Befestigungsflächen auf der Leiterplatte 14 sind wiederum mit nicht dargestellten Leiterbahnen auf der Leiterplatte 14 verbunden. Die Halterung 12 kann dadurch schnell, prozesssicher und vollautomatisch auf der Leiterplatte 14 befestigt und gleichzeitig elektrisch kontaktiert werden.

Die Halterung 12 ist mit drei ersten Rastarmen 24a, 24b und 24c versehen, die, wie noch erläutert werden wird, jeweils eine erste Rastnase aufweisen, wobei jede erste Rastnase eine Oberseite der Knopfzelle 16 abschnittsweise übergreift und dadurch die Knopfzelle 16 sicher an der Leiterplatte 14 hält. Die Rastarme 22a sind an einem Ende jeweils mit dem Grundkörper 18 verbunden und ragen senkrecht zur Oberseite der Leiterplatte 14 von dem Grundkörper 18 ab. Die ersten Rastarme 22a, 22b, 22c sind um etwa 120° über den Umfang der Halterung 12 gesehen voneinander beabstandet. Im Rahmen der Erfindung können auch lediglich zwei erste Rastarme oder auch mehr als drei Rastarme vorgesehen sein. Auch bei drei Rastarmen kann der Winkel, um den die ersten Rastarme voneinander beabstandet sind, variiert werden.

Die Halterung 12 weist weiter drei zweite Rastarme 22a, 22b, 22c auf. Auch die zweiten Rastarme 24a, 24b, 24c sind an einem Ende mit dem Grundkörper 18 verbunden und ragen senkrecht von der Oberseite der Leiterplatte 14 ab. Die zweiten Rastarme 24a, 24b, 24c sind jeweils mit einer zweiten Rastnase versehen, die aber im Zustand der Fig. 1 an einem äußeren Rand der Knopfzelle 16 anliegt. Wie noch erläutert werden wird, sind die zweiten Rastarme 24a, 24b, 24c zum Halten einer zweiten Knopfzelle mit gegenüber der Knopfzelle 16 geringerer Höhe vorgesehen, beispielsweise einer Knopfzelle vom Typ CR2025. Bei der Knopfzelle 16 gemäß Fig. 1 liegen die Rastnasen der zweiten Rastarme 24a, 24b, 24c am äußeren Rand der ersten Knopfzelle 16 an und tragen zu einem guten elektrischen Kontakt zwischen dem Rand der Knopfzelle 16 und der Halterung 12 bei. Die zweiten Rastarme 24a, 24b, 24c können im Rahmen der Erfindung auch so ausgebildet sein, dass sie dann, wenn zwei Knopfzellen gleicher oder unterschiedlicher Größe, beispielsweise zwei Knopfzellen CR2025, übereinander angeordnet werden, die obere Knopfzelle halten.

Die Halterung 12 weist darüber hinaus insgesamt sechs Einführarme 26a bis 26f auf. Die Einführarme 26a bis 26f ragen von der Leiterplatte 14 aus gesehen über die ersten Rastarme und die zweiten Rastarme hinaus. An ihrem, in Fig. 14 oberen Ende, das also am weitesten von der Leiterplatte 14 beabstandet ist, sind die Einführarme 26a bis 26f jeweils mit einem Einführabschnitt in Form einer Anlaufschräge versehen. Diese Anlaufschräge ist schräg radial nach außen angeordnet, wobei die Rastarme 26a bis 26f im Übrigen senkrecht von der Oberseite der Leiterplatte 14 abragen und mit dem Grundkörper 18 verbunden sind. Im Rahmen der Erfindung können die Einführarme auch entfallen oder es kann eine andere Anzahl an Einführarmen vorgesehen sein.

Wird die Knopfzelle 16 in Fig. 1 von oben her senkrecht zur Leiterplatte 14 und auf die Leiterplatte 14 zubewegt, berührt ein unterer Rand der Knopfzelle 16 zunächst die Anlaufschrägen an dem in Fig. 1 oberen Ende der Einführarme 26a. Die Anlaufschrägen an den Einführarmen 26a bis 26f sorgen dann dafür, dass die Knopfzelle in radialer Richtung exakt mittig zur Halterung 12 ausgerichtet wird, mit anderen Worten relativ zur Halterung 12 zentriert wird. Wird die Knopfzelle 16 dann weiter in Richtung auf die Leiterplatte 14 zugestellt, werden die ersten Rastarme 22a bis 22c und dann die zweiten Rastarme 24a bis 24c dadurch zuverlässig in radialer Richtung ausgelenkt. Die Knopfzelle 16 wird so weit in Richtung auf die Leiterplatte 14 zugestellt, bis eine Unterseite der Knopfzelle 16 in Fig. 1 nicht erkennbare zweite Kontakte auf der Oberseite der Leiterplatte 14 berührt und die ersten Rastarme 22a bis 22c wieder radial nach innen schnappen, so dass die ersten Rastnasen an den ersten Rastarmen 22a, 22b, 22c die Oberseite der Knopfzelle 16 abschnittsweise übergreifen und dadurch die Knopfzelle 16 sicher auf der Leiterplatte 14 halten.

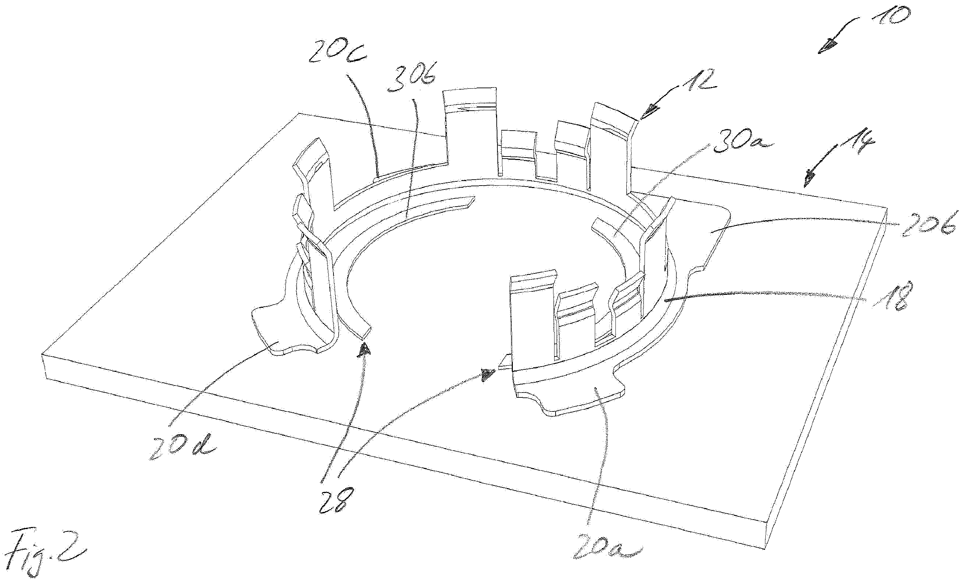

Fig. 2 zeigt die Anordnung 10 der Fig. 1 ohne die Knopfzelle 16. Zunächst ist zu erkennen, dass auf der Oberseite der Leiterplatte 14 innerhalb der Halterung 12 ein zweiter elektrischer Kontakt 28 gebildet ist, der zum elektrischen Kontaktieren der Unterseite der Knopfzelle 16 vorgesehen ist. Üblicherweise ist dies der Massekontakt. Der zweite Kontakt 28 weist zwei kreisringabschnittsförmige Kontaktflächen 30a, 30b auf, die einander gegenüberliegend angeordnet sind. Ein äußerer Rand der Kontaktflächen 30a, 30b ist jeweils parallel zum Grundkörper 18 der Halterung 12 angeordnet. Der Außenrand der Kontaktflächen 30a, 30b ist in vergleichsweise geringem Abstand zu dem Innenumfang des Grundkörpers 18 angeordnet. Der Abstand beträgt etwa 1/10 des Radius der Halterung 12. Der Abstand kann zwischen 1/5 und 1/20 des Radius der Halterung 12 liegen. Die Kontaktflächen 30a, 30b kontaktieren die Unterseite der Knopfzelle 16 dadurch nur geringfügig innerhalb von deren äußerem Rand. In diesem Bereich ist die Knopfzelle 16 vergleichsweise formstabil und weist bezüglich ihrer Abmessungen auch nur geringe Toleranzen auf. Das Vorsehen von kreisringabschnittsförmigen Kontaktflächen 30a, 30b oder auch nur einer kreisringförmigen Kontaktfläche sorgt dadurch für eine zuverlässige Kontaktierung der Knopfzelle 16. Durch die Form der Kontaktflächen 30a, 30b wird auch das Risiko von kurzschlüsseln bei der Montage von Knopfzellen minimiert. Die Kontaktflächen 30a, 30b sind mit nicht dargestellten Leiterbahnen auf der Oberseite der Leiterplatte 14 verbunden, um die Batteriespannung der Knopfzelle 16 einer nicht dargestellten Schaltung auf der Leiterplatte 14 zuzuführen. Im Rahme der Erfindung kann der Massekontakt auch mit beliebiger Form ausgebildet sein.

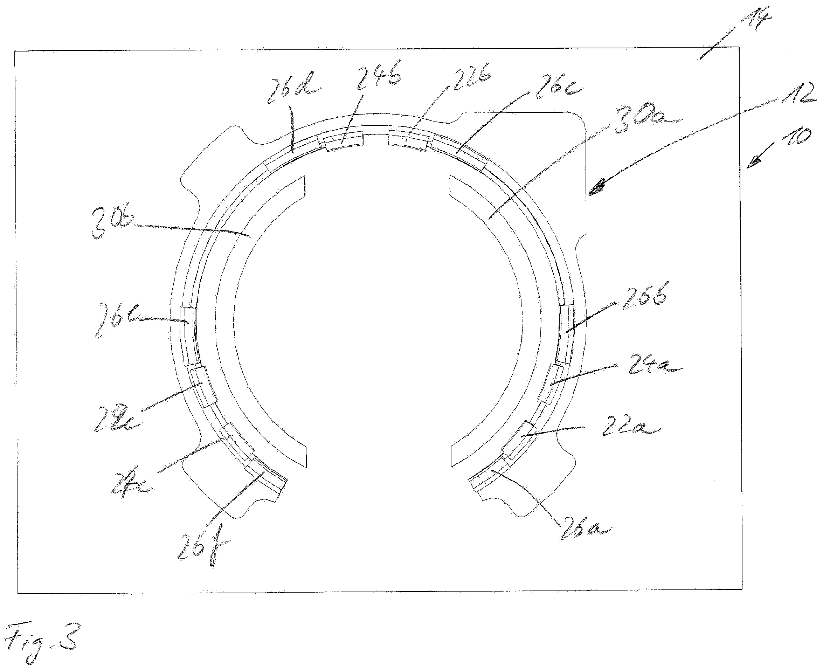

Fig. 3 zeigt die Anordnung 10 der Fig. 2 von oben. In Fig. 3 ist zu erkennen, dass die ersten Rastarme 22a, 22b und 22c jeweils um etwa 120° voneinander beabstandet sind. Auch die zweiten Rastarme 24a, 24b, 24c sind jeweils um etwa 120° voneinander beabstandet.

Jeweils zwei Rastarme 22a, 24a, 22b, 24b und 22c, 24c sind jeweils von zwei Einführarmen 26a bis 26f umgeben, gesehen in Umfangsrichtung der Halterung 12. Es ist in der Ansicht der Fig. 3 auch zu erkennen, dass die ersten Rastarme 22a und die zweiten Rastarme 24a mit ihren Rastnasen jeweils weiter in Richtung auf einen gedachten Mittelpunkt der Halterung 12 vorragen als die Einführarme 26a bis 26f. Dadurch können die Rastnasen an den Rastarmen 22a bis 22c und 24a bis 24c die Oberseite der Knopfzelle 16 abschnittsweise übergreifen und diese dadurch an der Oberseite der Leiterplatte 14 und speziell an den Kontaktflächen 30a, 30b auf der Leiterplatte 14 halten.

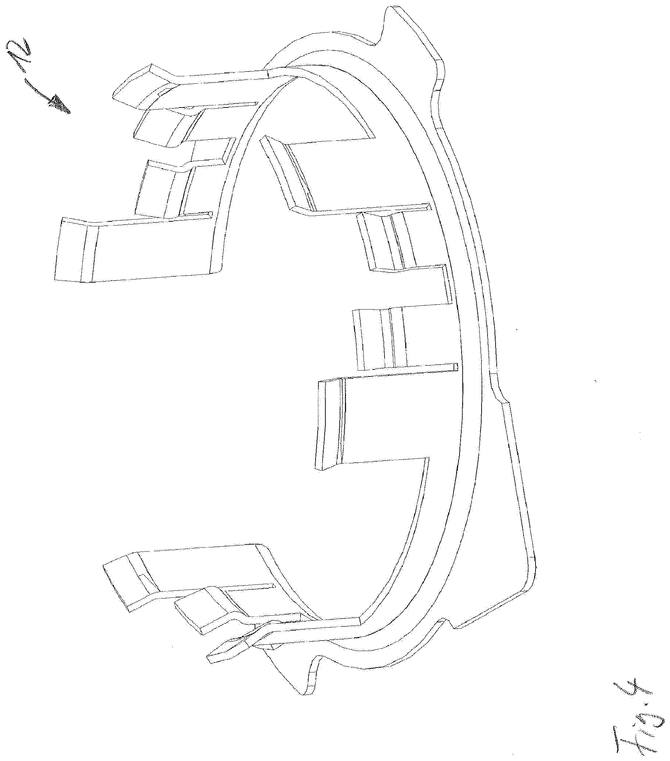

Fig. 4 zeigt die Halterung 12 in einer Ansicht von schräg oben.

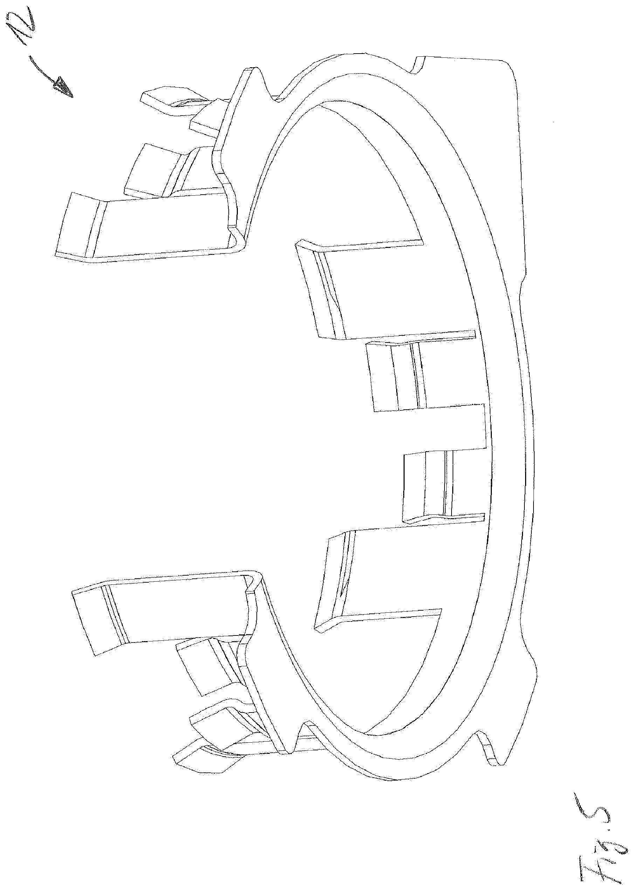

Fig. 5 zeigt die Halterung 12 in einer Ansicht von schräg unten.

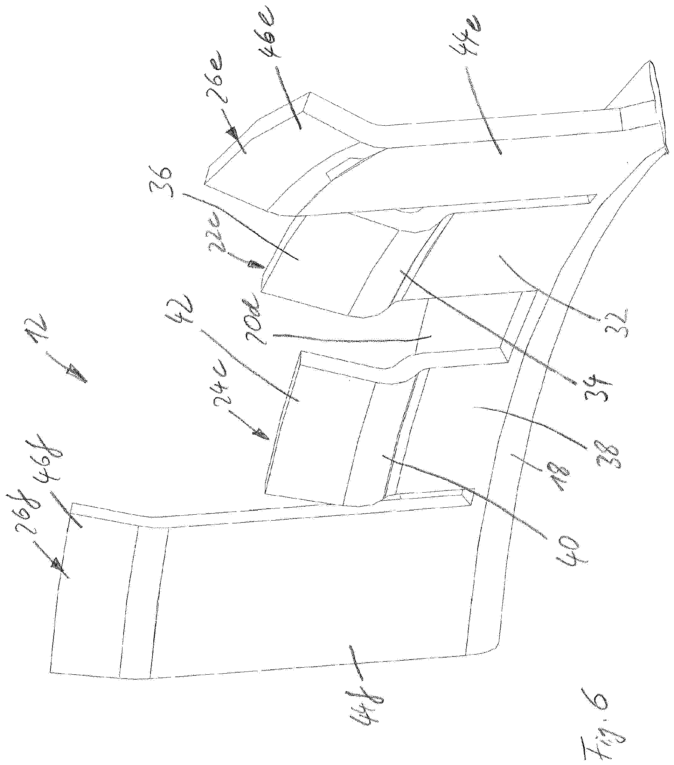

Fig. 6 zeigt eine vergrößerte, abschnittsweise Darstellung der Halterung 12, wobei lediglich zwei Einführarme 26a und 26f und der erste Rastarm 22c und der zweite Rastarm 24c sowie abschnittsweise die Befestigungsfläche 20d zu erkennen sind.

Alle Einführarme 26a bis 26f, alle ersten Rastarme 22a bis 22c und alle zweiten Rastarme 24a bis 24c sind an einem Ende mit dem Grundkörper 18 der Halterung 12 verbunden. Ausgehend vom Grundkörper 18 weisen alle ersten Rastarme 22c, wobei in Fig. 6 lediglich der Rastarm 22c dargestellt ist, einen Verbindungsabschnitt 32 auf, der als geradlinig verlaufender Blechstreifen ausgebildet ist. Der Verbindungsabschnitt geht dann in einen Halteabschnitt 34 über, der sich schräg nach innen erstreckt. Im montierten Zustand der Halterung 12 auf der Leiterplatte 14 erstreckt sich der Halteabschnitt 34 schräg zur Leiterplatte 14. Wie in Fig. 6 zu erkennen ist, erstreckt sich der Halteabschnitt schräg zum Verbindungsabschnitt 32 und in Richtung auf einen Innenraum der Halterung 12 zu, wobei in diesen Innenraum dann die Knopfzelle 16 eingesetzt wird. Der Halteabschnitt 34 bildet eine Rastnase aus, die im vollständig eingesetzten Zustand der Knopfzelle 16 abschnittsweise über die Oberseite der Knopfzelle 16 schnappt, vgl. Fig. 1.

Auf einer, dem Verbindungsabschnitt 32 gegenüberliegenden Seite des Halteabschnitts 34 geht dieser in einen Einführabschnitt 36 über, der ebenfalls schräg zum Verbindungsabschnitt 32 angeordnet ist, sich aber schräg vom Innenraum der Halterung 12 weg erstreckt. Der Einführabschnitt 36 bildet eine Anlaufschräge für den unteren Rand der Knopfzelle 16, wenn diese in die Halterung 12 eingesetzt wird. Wenn der untere Rand der Knopfzelle 16 auf den Einführabschnitt 36 aufläuft, wird der Rastarm 22c dadurch radial nach außen, in Fig. 6 also nach rechts, ausgelenkt. Der Rand der Knopfzelle kann dadurch an dem am weitesten innen liegenden Abschnitt des Halteabschnitts 34 oder dem am weitesten innen liegenden Abschnitt der Rastnase vorbeigleiten, bis die Rastnase bzw. der Halteabschnitt 34 sich wieder in Richtung auf den Innenraum der Halterung 12 zubewegen kann. Mit anderen Worten federt der Rastarm 22c dann zurück, so dass der Halteabschnitt 34 die Oberseite der Knopfzelle 16 abschnittsweise übergreifen kann.

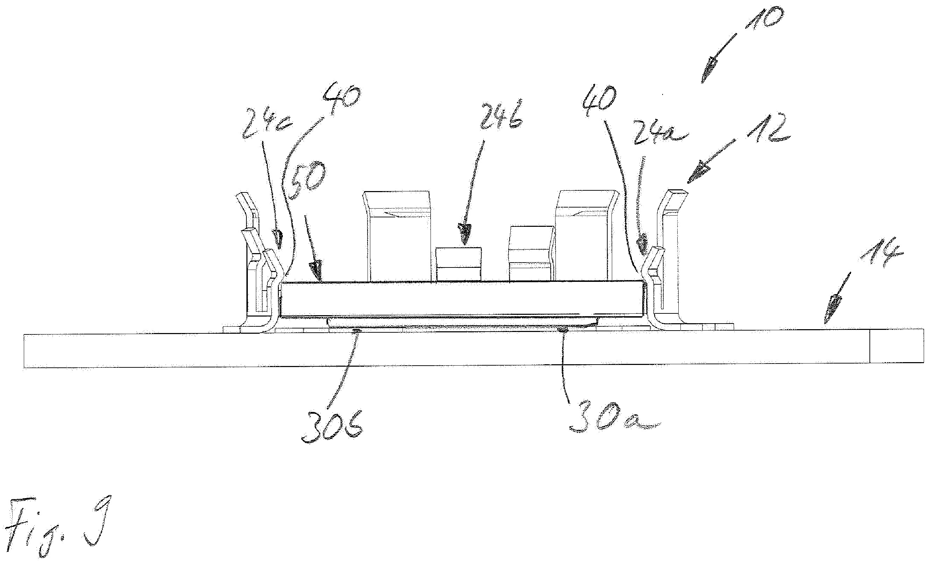

Der zweite Rastarm 24c und alle weiteren zweiten Rastarme 24a bis 24c sind gleich aufgebaut wie die ersten Rastarme 22a bis 22c, lediglich die zweite Rastnase bzw. der zweite Halteabschnitt 40 ist weniger weit von dem Grundkörper 18 beabstandet als der Halteabschnitt 34 am ersten Rastarm 22c. Dies wird dadurch erreicht, dass der Verbindungsabschnitt 38 des zweiten Rastarms 24c kürzer ist als der Verbindungsabschnitt 32 des ersten Rastarms 22c. Beim Einsetzen einer Knopfzelle wird der untere Rand der Knopfzelle 16 auf den Einführabschnitt 42 des zweiten Rastarms 24c auftreffen und den zweiten Rastarm 24c dadurch radial nach außen, in Fig. 6 also nach rechts oben, auslenken. Dadurch kann der untere Rand der Knopfzelle an der Rastnase bzw. dem Halteabschnitt 40 des zweiten Rastarms 24c vorbeigleiten. Der zweite Rastarm 24c verbleibt bei eingesetzter Knopfzelle 16, vgl. Fig. 1, aber in dem radial nach außen ausgelenkten Zustand und die Rastnase 40 liegt am äußeren Rand der Knopfzelle 16 an. Die zweiten Rastarme 24a, 24b, 24c können wieder zurückfedern, wenn eine Knopfzelle 50 mit geringer Höhe als die Knopfzelle 16 eingesetzt wird, siehe auch Fig. 9.

Die Einführarme 26e, 26f weisen jeweils einen Verbindungsabschnitt 44e, 44f auf, die jeweils mit dem Grundkörper 18 verbunden sind und senkrecht zur Leiterplatte 14 nach oben abragen, vgl. Fig. 1. Die Verbindungsabschnitte 44e, 44f der Einführarme 26e, 26f gehen an ihrem, dem Grundkörper 18 abgewandten Ende jeweils in einen Einführabschnitt 46e, 46f über, wobei die Einführabschnitte 46e, 46f sich schräg nach oben vom Innenraum der Halterung 12 weg erstrecken und dadurch jeweils eine Anlaufschräge bilden.

Wird die Knopfzelle 16 in Richtung auf die Halterung 12 zubewegt, so berührt der untere Rand der Knopfzelle 16 zunächst die Einführabschnitte 46e, 46f der Einführarme 26a bis 26f. Diese wirken als Anlaufschrägen und sorgen dafür, dass die Knopfzelle exakt mittig zur Halterung 12 ausgerichtet wird, indem die Knopfzelle 16 relativ zum Greifer oder zusammen mit dem Greifer gegebenenfalls parallel zur Leiterplatte verschoben wird. Der äußere Rand der Knopfzelle 16 ist in diesem Zustand dann geringfügig von einer Innenseite der Einführarme 26a bis 26f beabstandet oder liegt ohne Vorspannung an der Innenseite der Einführarme 26a bis 26f an. Die Verbindungsabschnitte 44e, 44f der Einführarme 26a bis 26f sorgen dann dafür, dass beim weiteren Zustellen der Knopfzelle 16 in Richtung auf die Leiterplatte 14 zu die Knopfzelle ihre radiale Position zur Halterung 12 behält und dann die Einführabschnitte 36, 42 der ersten Rastarme 22a bis 22c bzw. der zweiten Rastarme 24a bis 24c exakt trifft und diese dann in radialer Richtung nach außen auslenken kann.

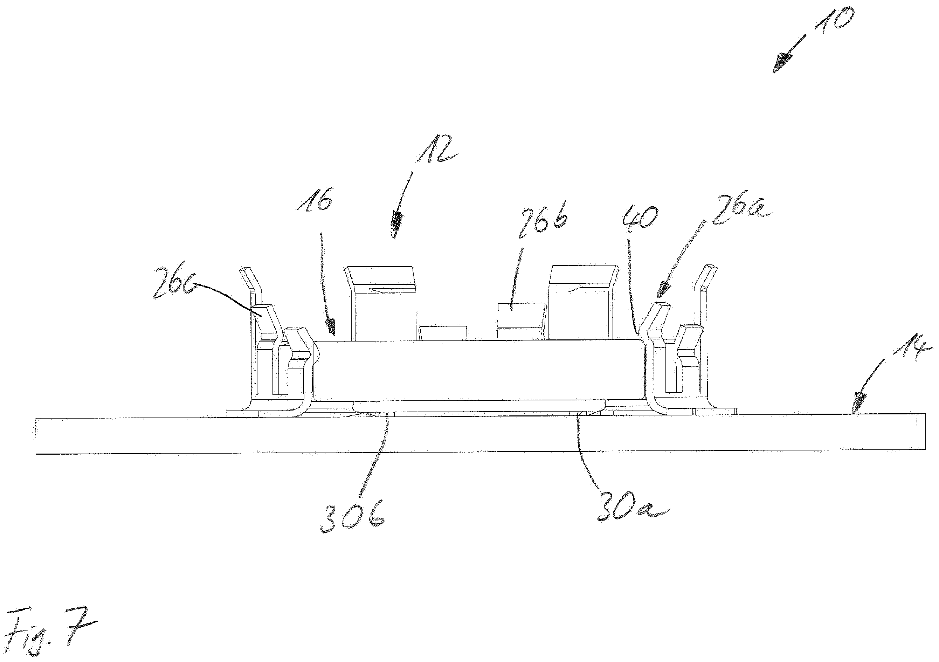

Fig. 7 zeigt eine Schnittansicht der Anordnung 10 der Fig. 1, wobei die Lage der Schnittebene so gewählt wurde, dass sie durch den ersten Rastarm 26a hindurchläuft.

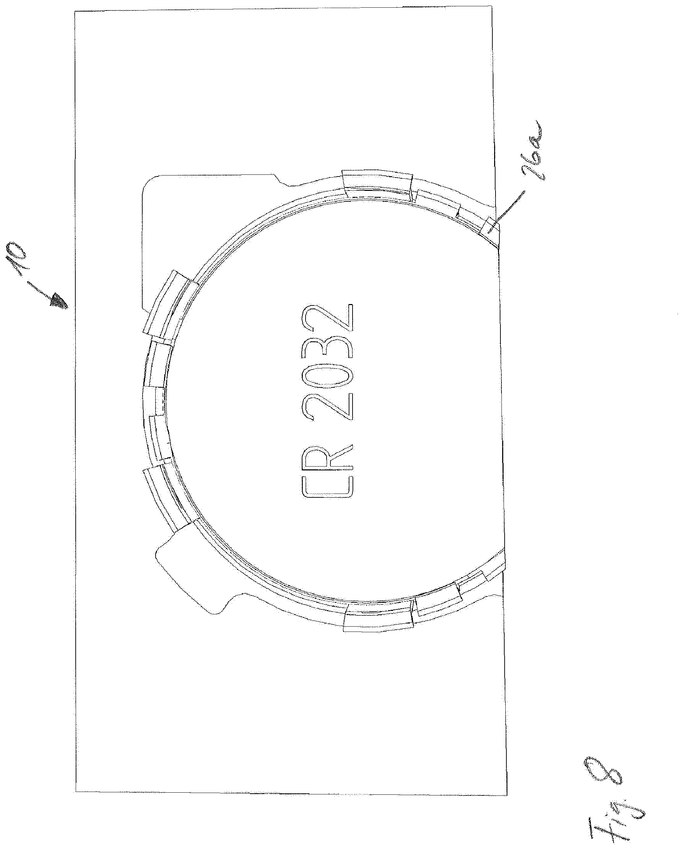

Die Lage der Schnittebene ist anhand der Fig. 8 zu erkennen, die eine Draufsicht auf die gemäß Fig. 7 geschnittene Anordnung 10 zeigt.

Es ist in Fig. 7 zu erkennen, dass die Rastnase 40 des ersten Rastarms 26a eine Oberseite der Knopfzelle 16 abschnittsweise übergreift und die Knopfzelle 16 dadurch an der Leiterplatte 14 hält. In Fig. 7 kann die Knopfzelle 16 infolgedessen nicht ohne weiteres nach oben, von der Leiterplatte 14 weg bewegt werden. Hierzu müsste die Knopfzelle aus der Halterung 12 herausgehebelt werden, um die Vorspannkraft der ersten Rastarme 26a bis 26c zu überwinden.

Eine Unterseite der Knopfzelle 16 wird, wie Fig. 7 ebenfalls zu entnehmen ist, gegen die kreisringabschnittsförmigen Kontaktflächen 30a, 30b auf der Leiterplatte 14 gedrückt.

Fig. 9 zeigt eine weitere Schnittansicht der erfindungsgemäßen Anordnung 10, wobei in die Halterung 12 eine zweite Knopfzelle 50 mit gegenüber der ersten Knopfzelle 16 geringerer Höhe eingesetzt wurde. Speziell ist die zweite Knopfzelle 50 vom Typ CR2025. Die Knopfzelle 50 weist somit einen Durchmesser von 20 mm und eine Höhe von 2,5 mm auf.

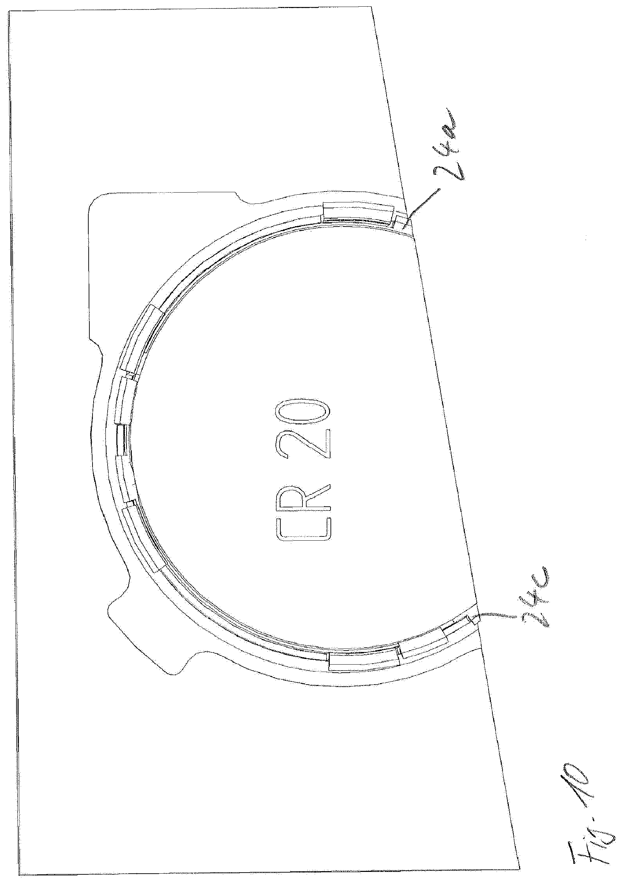

Die Schnittebene in Fig. 9 wurde so gelegt, siehe Fig. 10, dass die Schnittebene durch zwei zweite Rastarme 24a und 24c hindurchläuft. Es ist in Fig. 9 zu erkennen, dass die Rastnasen 40 der zweiten Rastarme 24a, 24c die Oberseite der Knopfzelle 50 abschnittsweise übergreifen und diese dadurch in der Halterung 12 und gegen die Oberseite der Leiterplatte 14 gedrückt halten. Die Unterseite der Knopfzelle 50 wird dadurch gegen die Kontaktflächen 30a, 30b auf der Oberseite der Leiterplatte 14 gedrückt.

Mit der erfindungsgemäßen Anordnung 10 ist es dadurch möglich, Knopfzellen unterschiedlicher Höhe zu kontaktieren und auf der Leiterplatte 14 zu halten. Es ist auch möglich, zwei oder mehr Knopfzellen mit unterschiedlicher oder gleicher Höhe übereinander in die Halterung einzusetzen und elektrisch zu kontaktieren.

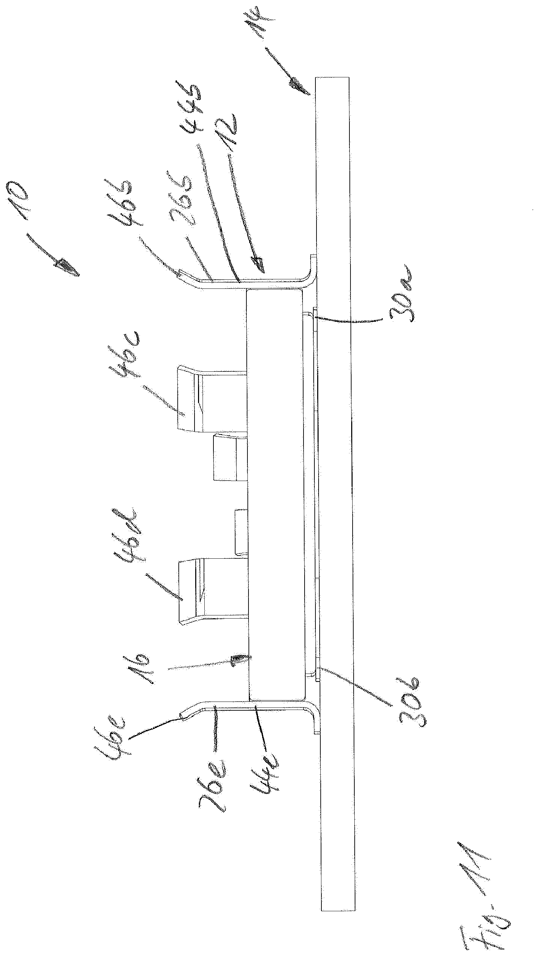

Die Darstellung der Fig. 11 zeigt eine weitere Schnittansicht der Anordnung 10 der Fig. 1. Die Schnittebene wurde in Fig. 11 aber so gewählt, dass sie durch zwei Einführarme 26b und 26e hindurchläuft. Es ist in dieser Ansicht zu erkennen, dass der äußere Rand der Knopfzelle 16 einen sehr geringen Abstand zur Innenseite der Einführarme 26b, 26e aufweist oder ohne Vorspannung an der Innenseite der Einführarme 26b, 26e anliegt. Wie bereits ausgeführt wurde, sorgen die Einführabschnitte 46 der Einführarme 26a bis 26f dafür, dass die Knopfzelle 16 oder die Knopfzelle 50 in radialer Richtung exakt zur Halterung 12 ausgerichtet wird, also parallel zur Leiterplatte 14. Die Verbindungsabschnitte 44 der Einführarme 26a bis 26f sorgen dann dafür, dass die Knopfzelle beim weiteren Zustellen in Richtung auf die Leiterplatte 14 zu in radialer Richtung geführt wird. Dadurch kann sichergestellt werden, dass die Einführschrägen der Rastarme durch den unteren Rand der Knopfzelle berührt werden, so dass dann die Rastarme beim weiteren Zustellen der Knopfzelle in Richtung auf die Leiterplatte 14 zu in radialer Richtung ausgelenkt werden. ---------------

## Patentansprüche

1. Halterung (12) für wenigstens eine Knopfzelle (16, 50), wobei die Halterung (12) zum Befestigen auf einer Leiterplatte (14) vorgesehen ist, wobei die Halterung (12) wenigstens zwei erste Rastarme (22a, 22b, 22c) aufweist, die im montierten Zustand der Halterung (12) von der Leiterplatte (14) abragen, wobei die Knopfzelle (16, 50) im montierten Zustand der Knopfzelle (16, 50) zwischen den ersten Rastarmen (22a, 22b, 22c) aufgenommen ist, wobei die ersten Rastarme (22a, 22b, 22c) an einem Ende jeweils mit einem Grundkörper (18) verbunden sind, der eine Grundfläche aufweist, die im montierten Zustand der Halterung (12) mit der Leiterplatte (14) verbunden ist, wobei die ersten Rastarme (22a, 22b, 22c) jeweils wenigstens eine erste Rastnase aufweisen, um die Knopfzelle (16, 50) an der Leiterplatte (14) zu halten, und wobei die ersten Rastnasen in einem ersten Abstand von der Grundfläche des Grundkörpers (18) angeordnet sind.

2. Halterung nach Anspruch 1, **dadurch gekennzeichnet, dass** die Halterung (12) wenigstens zwei zweite Rastarme (24a, 24b, 24c) aufweist, die im montierten Zustand der Halterung (12) von der Leiterplatte (14) abragen, wobei die Knopfzelle (16, 50) im montierten Zustand der Knopfzelle (16, 50) zwischen den zweiten Rastarmen (24a, 24b, 24c) aufgenommen ist, wobei die zweiten Rastarme (24a, 24b, 24c) an einem Ende jeweils mit dem Grundkörper (18) verbunden sind, wobei die zweiten Rastarme (24a, 24b, 24c) jeweils wenigstens eine zweite Rastnase aufweisen, um eine Knopfzelle (50) mit von der ersten Knopfzelle (16) unterschiedlicher Höhe oder eine weitere Knopfzelle an der Leiterplatte (14) zu halten, und wobei die zweiten Rastnasen in einem zweiten Abstand von der Grundfläche des Grundkörpers (18) angeordnet sind, wobei der zweite Abstand von dem ersten Abstand verschieden ist.

3. Halterung nach Anspruch 1 oder 2, **dadurch gekennzeichnet, dass** die Rastarme (22a, 22b, 22c, 24a, 24b, 24c) und der Grundkörper (18) elektrisch leitfähig ausgebildet sind.

4. Halterung nach Anspruch 1, 2 oder 3, **dadurch gekennzeichnet, dass** die Rastarme (22a, 22b, 22c, 24a, 24b, 24c) als gebogene Blechstreifen ausgebildet sind.

5. Halterung nach wenigstens einem der vorstehenden Ansprüche, **dadurch gekennzeichnet, dass** die Halterung (12) als einstückiges Blechstanz- und Blechbiegeteil ausgebildet ist.

6. Halterung nach wenigstens einem der vorstehenden Ansprüche, **dadurch gekennzeichnet, dass** wenigstens eine der Rastnasen mittels eines wenigstens abschnittsweise parallel zur Leiterplatte und/oder wenigstens abschnittsweise schräg zur Leiterplatte angeordneten Halteabschnitts (34, 40) gebildet ist.

7. Halterung nach Anspruch 6, **dadurch gekennzeichnet, dass** jeder Rastarm einen Verbindungsabschnitt (32, 38) aufweist, der einerseits mit dem Grundkörper (18) und andererseits mit dem Halteabschnitt (34, 40) verbunden ist und dass der Halteabschnitt (34, 40) auf einer, dem Verbindungsabschnitt (32, 38) gegenüberliegenden Seite mit einem Einführabschnitt (36, 42) verbunden ist, der im montierten Zustand der Halterung (12) wenigstens abschnittsweise schräg zur Leiterplatte (14), zum Verbindungsabschnitt (32, 38) und/oder zum Grundkörper (18) angeordnet ist.

8. Halterung nach wenigstens einem der vorstehenden Ansprüche, **dadurch gekennzeichnet, dass** die Halterung (12) wenigstens zwei Einführarme (26a, 26b, 26c, 26d, 26e, 26f) aufweist, die im montierten Zustand der Halterung (12) von der Leiterplatte (14) abragen, wobei die Knopfzelle (16, 50) im montierten Zustand der Knopfzelle (16, 50) zwischen den Einführarmen (26a, 26b, 26c, 26d, 26e, 26f) aufgenommen ist und wobei die Einführarme (26a, 26b, 26c, 26d, 26e, 26f) an einem Ende mit dem Grundkörper (18) verbunden sind und wobei ein zweites Ende der Einführarme (26a, 26b, 26c, 26d, 26e, 26f), das dem ersten Ende gegenüberliegt, weiter von der Grundfläche des Grundkörpers (18) beabstandet ist als die ersten und zweiten Rastnasen.

9. Halterung nach wenigstens einem der vorstehenden Ansprüche, **dadurch gekennzeichnet, dass** der Grundkörper (18) eine gebogene Form aufweist und einen Rand der Knopfzelle (16, 50) im montierten Zustand der Halterung (12) und der Knopfzelle (16, 50) wenigstens abschnittsweise umgibt.

10. Halterung nach Anspruch 9, **dadurch gekennzeichnet, dass** der Grundkörper (18) ringförmig oder ringabschnittsförmig ausgebildet ist.

11. Halterung nach wenigstens einem der vorstehenden Ansprüche, **dadurch gekennzeichnet, dass** die Grundfläche des Grundkörpers (18) wenigstens zwei Befestigungsabschnitte (20a, 20b, 20c, 20d) aufweist, die im montierten Zustand der Halterung (12) auf der Leiterplatte (14) aufliegen.

12. Halterung nach Anspruch 11, **dadurch gekennzeichnet, dass** wenigstens einer der Befestigungsabschnitte (20b) als Ansaugfläche für einen Unterdruckgreifer ausgebildet ist.

13. Halterung nach wenigstens einem der vorstehenden Ansprüche, **dadurch gekennzeichnet, dass** drei erste Rastarme (22a, 22b, 22c), drei zweite Rastarme (24a, 24b, 24c) und/oder wenigstens drei Einführarme (26a, 26b, 26c, 26d, 26e, 26f), insbesondere sechs Einführarme, mit dem Grundköper (18) verbunden sind.

14. Anordnung mit einer Halterung (12) nach wenigstens einem der vorstehenden Ansprüche und einer Leiterplatte (14), wobei die Halterung (12) so auf der Leiterplatte (14) befestigt ist, dass die wenigstens zwei ersten Rastnasen in einer ersten Höhe oberhalb der Leiterplatte (14) angeordnet sind.

15. Anordnung nach Anspruch 14, **dadurch gekennzeichnet, dass** die zweiten Rastnasen in einer zweiten Höhe, die von der ersten Höhe verschieden ist, oberhalb der Leiterplatte (14) angeordnet sind.

16. Anordnung nach Anspruch 14 oder 15, **dadurch gekennzeichnet, dass** die wenigstens zwei Einführarme (26a, 26b, 26c, 26d, 26e, 26f) von der Leiterplatte (14) aus gesehen über die ersten Rastarme (22a, 22b, 22c) und/oder die zweiten Rastarme (24a, 24b, 24c) hinausragen.

17. Anordnung nach Anspruch 14, 15 oder 16, **dadurch gekennzeichnet, dass** wenigstens ein Abschnitt der Halterung (12) einen ersten elektrischen Kontakt zum Kontaktieren einer in der Halterung angeordneten Knopfzelle bildet und dass auf der Leiterplatte (14) wenigstens ein zweiter elektrischer Kontakt (28) zum Kontaktieren der in der Halterung (12) angeordneten Knopfzelle (16, 50) angeordnet ist, wobei der zweite elektrische Kontakt (28) wenigstens eine kreisringabschnittsförmige oder kreisringförmige Kontaktfläche (30a, 30b) aufweist.

18. Anordnung nach Anspruch 17, **dadurch gekennzeichnet, dass** eine Außenkante der Kontaktfläche (30a, 30b), in radialer Richtung und parallel zur Leiterplatte (14) gesehen, nur um 1/20 bis 1/5 des Radius der Knopfzelle (16, 50), insbesondere 1/20 bis 1/10 des Radius der Knopfzelle, von dem ersten und/oder zweiten Rastarm (22a, 22b, 22c, 24a, 24b, 24c) beabstandet ist.

19. Verfahren zum automatischen Montieren einer Halterung (12) nach wenigstens einem der vorstehenden Ansprüche auf einer Leiterplatte (14), wobei die Halterung (12) wenigstens einen Befestigungsabschnitt (20b) aufweist, an dem ein Greifer angreifen kann, mit den Schritten Ergreifen der Halterung (12) mittels Angreifen des Greifers an dem Befestigungsabschnitt (20b), Positionieren der Halterung (12) relativ zu Anschlussflächen auf der Leiterplatte (14) und Aufsetzen der Halterung (12) auf die Leiterplatte (14).

20. Verfahren nach Anspruch 19, mit dem Schritt Verlöten der Halterung mit wenigstens einer Anschlussfläche auf der Leiterplatte (14).
